(19) **Europäisches Patentamt / European Patent Office / Office européen des brevets**

(11) **EP 3 355 432 B1**

(12) **EUROPÄISCHE PATENTSCHRIFT**

(45) Veröffentlichungstag und Bekanntmachung des Hinweises auf die Patenterteilung:
**14.07.2021  Patentblatt 2021/28**

(51) Int Cl.:
*H02H 3/28* *(2006.01)*     *H04B 1/7073* *(2011.01)*
*H04J 3/06* *(2006.01)*

(21) Anmeldenummer: **17152981.1**

(22) Anmeldetag: **25.01.2017**

(54) **VERFAHREN ZUM BESTIMMEN EINES ZEITVERSATZES ZWISCHEN MESSWERTEN**

METHOD FOR DETERMINING A TIME OFFSET BETWEEN MEASURED VALUES

PROCÉDÉ DE DÉTERMINATION D'UN DÉLAI DE TEMPORISATION ENTRE DEUX VALEURS DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.08.2018  Patentblatt 2018/31**

(73) Patentinhaber: **Siemens Aktiengesellschaft 80333 München (DE)**

(72) Erfinder:
• **Jurisch, Andreas**
  **16727 Schwante (DE)**
• **Kerger, Torsten**
  **14621 Schönwalde-Glien (DE)**
• **Matussek, Robert**
  **10249 Berlin (DE)**

(56) Entgegenhaltungen:
**WO-A1-2012/061978     JP-A- S 648 821**

**Beschreibung**

Die Erfindung bezieht sich auf ein Verfahren zum Bestimmen eines Zeitversatzmesswertes, der den Zeitversatz zwischen einem ersten Messwert, der mit einem an einer ersten Stelle einer elektrischen Leitung oder eines elektrischen Netzes angeordneten Messgerät erfasst worden ist, und zumindest einem zweiten Messwert, der mit zumindest einem an einer zweiten Stelle der elektrischen Leitung oder des elektrischen Netzes angeordneten Messgerät ermittelt worden ist, angibt, wobei als erster Messwert ein erster Messzeiger und als zweiter Messwert ein zweiter Messzeiger ermittelt wird, mit dem ersten und zweiten Messzeiger unter Heranziehung eines den Leitungsabschnitt bzw. Netzabschnitt zwischen der ersten und zweiten Stelle beschreibenden Leitungsmodells ein leitungsbedingter Phasendifferenzwert, der den leitungsbedingten Phasenversatz zwischen dem ersten und zweiten Messzeiger bei synchroner Messzeigermessung beschreibt, und ein messgerätebedingter Phasendifferenzwert, der auf einem Zeitversatz zwischen den Messzeigern im Falle einer asynchronen Messzeigerermittlung der Messgeräte beruht, bestimmt wird und der Zeitversatzmesswert allein durch den messgerätebedingten Phasendifferenzwert oder unter Heranziehung des messgerätebedingten Phasendifferenzwerts gebildet wird, und wobei das Leitungsmodell durch eine Maschengleichung einer durch die erste und zweite Stelle begrenzten elektrischen Masche beschrieben wird oder eine solche Masche zumindest auch umfasst.

Auf dem Gebiet des Differentialschutzes ist es bekannt, Messgeräte auf der Basis von GPS-Signalen zu synchronisieren. Problematisch bei dieser Vorgehensweise ist allerdings der mögliche Ausfall der Satellitenverbindung (z. B. bei Gewitter). Erfolgt nämlich während des Satellitenausfalls ein Umrouten der Kommunikationsverbindung zwischen den Messgeräten, dann können die Messwerte von einem Differentialschutz wegen Wegfalls der Zeitinformation nicht mehr verarbeitet werden und es kann zum Ausfall der Differentialschutzfunktion kommen.

Alternativ besteht die Möglichkeit, spezielle IP-Netzwerkkomponenten einzusetzen, die einen synchronen Takt für alle an diesem Netzwerk angeschlossenen Geräte bereitstellen können; solche Netzwerke sind jedoch aufwändig.

Ein Verfahren mit den Merkmalen gemäß dem Oberbegriff des Patentanspruchs 1 ist aus der WO 2012/061978 A1 bekannt. Ein weiteres im Umfeld der Erfindung angesiedeltes Verfahren ist aus der europäischen Offenlegungsschrift EP 2 693 586 A1 bekannt.

Der Erfindung liegt die Aufgabe zugrunde, ein Verfahren anzugeben, das eine einfache, aber dennoch genaue Bestimmung von Zeitversatzmesswerten ermöglicht, insbesondere mit Blick auf eine nachfolgende Synchronisierung von Messgeräten.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass eine Kostenfunktion, die auf der Maschengleichung basiert und einen Phasenversatz zwischen den Messzeigern als Funktionsparameter aufweist, minimiert wird und der zu dem Auftreten des Minimalwerts der Kostenfunktion führende optimale Funktionsparameterwert als messgerätebedingter Phasendifferenzwert angesehen wird.

Ein wesentlicher Vorteil des erfindungsgemäßen Verfahrens ist darin zu sehen, dass auf der Grundlage eines Leitungsmodells der Leitung sowie von Messzeigern mit hoher Genauigkeit Zeitversatzwerte ermittelt werden können, die eine Synchronisierung der Messgeräte ermöglichen.

Erfindungsgemäß wird das Leitungsmodell durch eine Maschengleichung einer durch die erste und zweite Stelle begrenzten elektrischen Masche beschrieben oder umfasst eine solche Masche zumindest auch.

Außerdem wird erfindungsgemäß eine Kostenfunktion, die auf der Maschengleichung basiert und den Phasenversatz zwischen den Messzeigern als Funktionsparameter aufweist, minimiert. Der zu dem Auftreten des Minimalwerts der Kostenfunktion führende optimale Funktionsparameterwert wird bevorzugt als messgerätebedingter Phasendifferenzwert angesehen.

Die Kostenfunktion lautet vorzugsweise:

$$ f\left(\varphi_{Opt}\right)= abs\left(\underline{U}_A + \underline{Z}_{AB} \cdot \left(\underline{I}_A - \underline{U}_A \cdot \underline{Y}_{AA}\right) - \underline{U}'_B \cdot e^{-i\varphi_{Opt}}\right) $$

wobei der erste und zweite Messzeiger jeweils Spannungszeiger sind und wobei $f(\varphi_{Opt})$ die Kostenfunktion, $\underline{U}_A$ den ersten Spannungszeiger, $\underline{U}_B$ den zweiten Spannungszeiger, $\underline{Y}_{AA}$ einen Parallelleitwert des Leitungsmodells, $\underline{I}_A$ einen an der ersten Stelle erfassten Stromzeiger, $\underline{Z}_{AB}$ einen Leitungswiderstand des Leitungsmodells und $\varphi_{Opt}$ den optimalen Funktionsparameterwert bezeichnet.

Der leitungsbedingte Phasendifferenzwert wird bevorzugt ermittelt durch Differenzbildung zwischen dem Differenzphasenwinkel zwischen dem ersten und zweiten Messzeiger und dem messgerätebedingten Phasendifferenzwert. Darüber hinaus ist es vorteilhaft, wenn der messgerätbedingte Phasendifferenzwert zu einem vorgegebenen zweiten, späteren Zeitpunkt erneut ermittelt wird.

Der messgerätbedingte Phasendifferenzwert zu dem zweiten Zeitpunkt wird vorzugsweise unter Heranziehung eines an der ersten Stelle zu dem zweiten Zeitpunkt erfassten dritten Messzeigers und dem korrespondierenden Messzeiger, nachfolgend vierter Messzeiger genannt, der zweiten Stelle errechnet.

Besonders vorteilhaft ist es wenn die Messzeiger Spannungszeiger sind und der messgerätbedingte Phasendifferenzwert zum zweiten Zeitpunkt ermittelt wird gemäß:

$$\varphi_{F(k),A} = \Delta\varphi_{F(k),A} + \varphi_{F,0} = (\varphi_{U(k),B} - \varphi_{U(k),A}) - (\varphi_{U(k=0),B} - \varphi_{U(k=0),A}) + \varphi_{F,0}$$

wobei bezeichnet:

$\varphi_{F(k),A}$ den Phasendifferenzwert zum zweiten Zeitpunkt,
$\varphi_{U(k=0),A}$ den Phasenwinkel des ersten Spannungszeigers,
$\varphi_{U(k=0),B}$ den Phasenwinkel des zweiten Spannungszeigers,
$\varphi_{U(k),A}$ den Phasenwinkel des dritten Spannungszeigers,
$\varphi_{U(k),B}$ den Phasenwinkel des vierten Spannungszeigers und
$\varphi_{F,0}$ den messgerätebedingten Phasendifferenzwert zum ersten Zeitpunkt.

Auch ist es von Vorteil, wenn ein messgerätebedingter Verzögerungswert, der den Zeitversatz zwischen den Zeitbasen der Messgeräte zum zweiten Zeitpunkt angibt, ermittelt wird gemäß:

$$\Delta t = \frac{\Delta\varphi_{F(k),A}}{2\pi f}$$

wobei $\Delta t$ den messgerätebedingten Verzögerungswert und f die Netzfrequenz auf der elektrischen Leitung bzw. im elektrischen Netz bezeichnet.

Im Übrigen ist es vorteilhaft, wenn ein Frequenzdifferenzwert ermittelt wird, der die Differenz zwischen der zeitlichen Zeigerermittlungsrate des ersten Messgerätes und der des zweiten Messgerätes angibt.

Der Frequenzdifferenzwert wird vorzugsweise ermittelt gemäß:

$$\Delta fs = \frac{\Delta\varphi_{F(k),A}}{t2 - t1}$$

wobei t2 den zweiten Zeitpunkt und t1 den ersten Zeitpunkt bezeichnet.

Der messgerätebedingte Phasendifferenzwert wird bevorzugt zum Verstellen, insbesondere Synchronisieren, der Zeigerermittlungsrate des ersten und/oder zweiten Messgerätes herangezogen.

Mit Blick auf die Durchführung des Verfahrens wird es außerdem als vorteilhaft angesehen, wenn zumindest eines der Messgeräte, insbesondere das zweite Messgerät, seine Messzeiger an mindestens ein anderes Messgerät, insbesondere das erste Messgerät, übermittelt und zumindest ein Messgerät, das Messzeiger von einem anderen Messgerät empfängt, - insbesondere das erste Messgerät - den messgerätebedingten Phasendifferenzwert bildet.

Im Falle eines Fehlers, insbesondere im Falle eines Kurzschlusses auf der elektrischen Leitung, werden vorzugsweise neue messgerätbedingte Phasendifferenzwerte (bzw. alle weiteren messgerätbedingte Phasendifferenzwerte nach Fehlereintritt) auf der Basis des oder der vor Fehlereintritt ermittelten Frequenzdifferenzwerte berechnet, insbesondere fortgeschrieben.

Eine Synchronisation der Messgeräte erfolgt vorzugsweise auf der Basis der neuen, insbesondere der fortgeschriebenen, messgerätbedingten Phasendifferenzwerte.

Die Erfindung bezieht sich darüber hinaus auf ein Messgerät zum Bestimmen eines Zeitversatzmesswertes, der den Zeitversatz zwischen einem ersten Messwert, den das Messgerät an einer ersten Stelle einer elektrischen Leitung oder eines elektrischen Netzes erfasst, und zumindest einem zweiten Messwert, der mit zumindest einem an einer zweiten Stelle der elektrischen Leitung oder des elektrischen Netzes angeordneten zweiten Messgerät ermittelt worden ist, angibt, wobei das Messgerät derart ausgebildet ist, dass es als ersten Messwert einen ersten Messzeiger ermittelt, mit dem ersten Messzeiger und einem als zweiten Messwert erhaltenen zweiten Messzeiger unter Heranziehung eines den Leitungsabschnitt bzw. Netzabschnitt zwischen der ersten und zweiten Stelle beschreibenden Leitungsmodells einen leitungsbedingten Phasendifferenzwert, der den leitungsbedingten Phasenversatz zwischen dem ersten und zweiten Messzeiger bei synchroner Messzeigermessung beschreibt, und einen messgerätebedingten Phasendifferenzwert, der auf einem Zeitversatz zwischen den Messzeigern im Falle einer asynchronen Messzeigerermittlung der Messgeräte beruht, bestimmt und den messgerätebedingten Phasendifferenzwert als den Zeitversatzmesswert ausgibt oder den Zeitversatzmesswert unter Heranziehung des messgerätebedingten Phasendifferenzwerts bildet; und wobei das Leitungsmodell durch eine Maschengleichung einer durch die erste und zweite Stelle begrenzten elektrischen Masche beschrieben wird oder eine solche Masche zumindest auch umfasst.

Erfindungsgemäß ist bezüglich eines solchen Messgeräts vorgesehen, dass das Messgerät derart ausgebildet ist, dass es eine Kostenfunktion, die auf der Maschengleichung basiert und einen Phasenversatz zwischen den Messzeigern als Funktionsparameter aufweist, minimiert und den zu dem Auftreten des Minimalwerts der Kostenfunktion führenden optimalen Funktionsparameterwert als messgerätebedingter Phasendifferenzwert ansieht.

Bezüglich der Vorteile des erfindungsgemäßen Messgeräts sei auf die obigen Ausführungen im Zusammenhang mit dem erfindungsgemäßen Verfahren verwiesen.

Die Erfindung bezieht sich außerdem auf eine Anordnung mit einem Messgerät - wie oben beschrieben ist, nachfolgend erstes Messgerät genannt - und einem zweiten Messgerät, das die Messzeiger an der zweiten Stelle der elektrischen Leitung oder des elektrischen Netzes ermittelt und diese an das erste Messgerät übermittelt.

Die Erfindung wird nachfolgend anhand von Ausführungsbeispielen näher erläutert; dabei zeigen beispielhaft

Figur 1     einen Abschnitt einer elektrischen Leitung, an die zwei Messgeräte angeschlossen sind,

Figur 2     ein Zeigerdiagramm mit von den Messgeräten gemäß Figur 1 ermittelten Spannungszeigern,

Fig.3-5     Phasenverläufe von den Messgeräten gemäß Figur 1 ermittelten Spannungszeigern über der Zeit, und

Figur 6     ein Ausführungsbeispiel für ein erfindungsgemäßes Messgerät, das an die Leitung gemäß Figur 1 anschließbar ist.

In den Figuren werden der Übersicht halber für identische oder vergleichbare Komponenten stets dieselben Bezugszeichen verwendet.

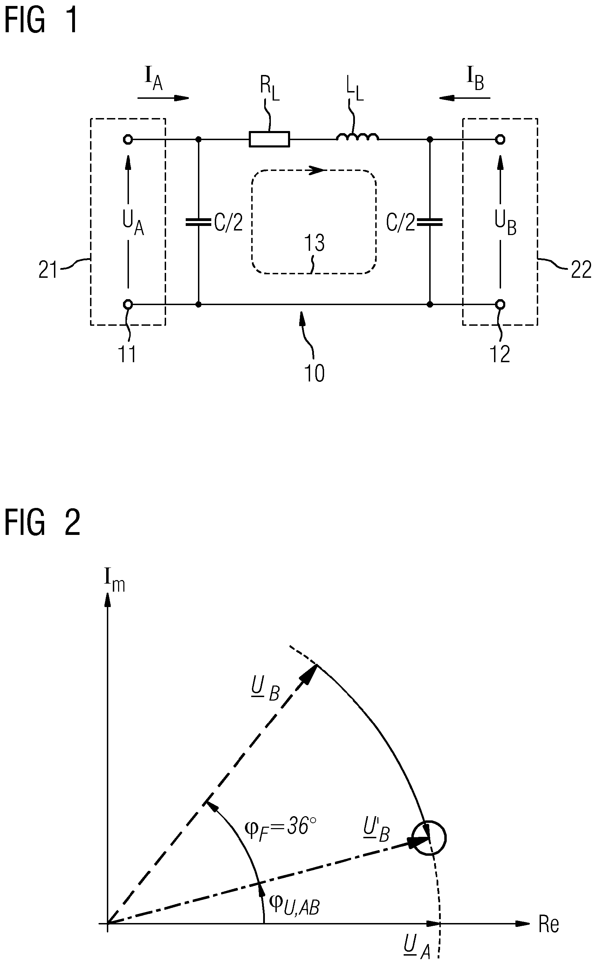

Die Figur 1 zeigt eine elektrische Leitung 10. An einer ersten Stelle 11 der elektrischen Leitung 10 ist ein erstes Messgerät 21 und an einer zweiten Stelle 12 der elektrischen leitung 10 ein zweites Messgerät 22 angeschlossen. In der Figur 1 ist der Leitungswiderstand zwischen den zwei Stellen 11 und 12 der elektrischen Leitung 10 mit dem Bezugszeichen $R_L$, die Induktivität der elektrischen Leitung 10 mit dem Bezugszeichen $L_L$ und die Parallelkapazitäten der elektrischen Leitung 10 mit dem Bezugszeichen C gekennzeichnet.

Zwischen der ersten und zweiten Stelle 11 bzw. 12 wird elektrisch eine elektrische Masche 13 gebildet. Für die Masche 13 lässt sich folgende Maschengleichung aufstellen:

$$\underline{U}_A + \underline{Z}_{AB} \cdot \left(\underline{I}_A - \underline{U}_A \cdot \underline{Y}_{AA}\right) - \underline{U}_B' = 0$$

wobei $\underline{U}_A$ einen ersten Spannungszeiger, der an der ersten Stelle 11 von dem ersten Messgerät 21 erfasst wird, $\underline{U}_B$ einen Spannungszeiger, der an der zweiten Stelle 12 von dem zweiten Messgerät 22 zeitlich synchron zur ersten Stelle 11 erfasst wird, $\underline{Y}_{AA}$ einen Parallelleitwert der Leitung 10, $\underline{I}_A$ einen Stromzeiger, der an der ersten Stelle 11 von dem ersten Messgerät 21 erfasst wird, und $\underline{Z}_{AB}$ einen Leitungswiderstand der Leitung 10 bezeichnet.

Der Parallelleitwert $\underline{Y}_{AA}$ der Leitung 10 und der Leitungswiderstand der Leitung 10 lassen sich wie folgt bestimmen:

$$\underline{Z}_{AB} = R_L + j \cdot 2\pi \cdot f \cdot L_L$$

$$\underline{Y}_{AA} = j \cdot 2\pi \cdot f \cdot \frac{C}{2}$$

wobei f die Netzfrequenz auf der elektrischen Leitung 10 bezeichnet.

Der Spannungszeiger $\underline{U}_B$ weist wegen der Synchronität der Messwerterfassung gegenüber dem ersten Spannungszeiger $\underline{U}_A$ eine Phasendifferenz auf, die allein leitungsbedingt ist.

Im Falle einer asynchronen Messwerterfassung an den beiden Stellen 11 und 12 wird anstelle des Spannungszeigers $\underline{U}_B'$ an der zweiten Stelle 12 von dem zweiten Messgerät 22 jedoch ein Spannungszeiger, nachfolgend zweiter

Spannungszeiger $\underline{U}_B$ genannt, ermittelt, der zusätzlich zu dem messgerätebedingten Phasenversatz eine Phasendifferenz aufweist, die auf der asynchronen Messzeigerermittlung beruht; in diesem Falle gilt:

$$\underline{U}_B = \underline{U}_B^{'} \cdot e^{j\varphi_F}$$

bzw.

$$\underline{U}_B^{'} = \underline{U}_B \cdot e^{-j\varphi_F}$$

wobei $\varphi_F = 2\pi f \cdot t_{AB}$ den Fehlwinkel aufgrund der Asynchronität der Messwerterfassung und $t_{AB}$ den Zeitversatz der Messungen bezeichnet. Sollen die an den beiden Stellen 11 und 12 erfassten Messzeiger zeitlich synchronisiert werden, so ist der Fehlwinkel $\varphi_F$ bzw. der Zeitversatz $t_{AB}$ zu ermitteln. Dies ist, wie nachfolgend erläutert wird, anhand der obigen Maschengleichung möglich, obwohl diese für $\underline{U}_B^{'}$ wegen des Phasenfehlers nicht mehr erfüllt ist, denn es lässt sich folgende Kostenfunktion $f(\varphi)$ aufstellen:

$$f(\varphi) = abs\left(\underline{U}_A + \underline{Z}_{AB} \cdot \left(\underline{I}_A - \underline{U}_A \cdot \underline{Y}_{AA}\right) - \underline{U}_B \cdot e^{-i\varphi}\right)$$

Die Kostenfunktion basiert auf der obigen Maschengleichung und weist den Phasenversatz $\varphi$ zwischen den an den beiden Stellen 11 und 12 erfassten Messzeigern als Funktionsparameter auf.

Für den optimalen Funktionsparameterwert $\varphi_{Opt}$ wird die Kostenfunktion minimal:

$$f\left(\varphi_{Opt}\right) = abs\left(\underline{U}_A + \underline{Z}_{AB} \cdot \left(\underline{I}_A - \underline{U}_A \cdot \underline{Y}_{AA}\right) - \underline{U}_B \cdot e^{-i\varphi_{Opt}}\right) \Rightarrow Min$$

Bei minimaler Kostenfunktion gibt der Funktionsparameterwert $\varphi_{Opt}$ den messgerätebedingten Phasendifferenzwert $\varphi_F$ an. Der leitungsbedingte Fehlwinkel lässt sich durch Differenzbildung ermitteln gemäß:

$$\varphi_{U,AB} = \varphi_{ist} - \varphi_F = \varphi_{ist} - \varphi_{Opt}$$

wobei $\varphi_{ist}$ den gesamten Phasenwinkel zwischen $\underline{U}_B$ und $\underline{U}_A$ bezeichnet, also die Phasenwinkelsumme aus der leitungsbedingten Phasendifferenz und dem messbedingten Fehlwinkel.

Der messgerätebedingte Zeitversatz $t_{AB}$ zwischen den Zeitbasen der Messgeräte 21 und 22 lässt sich ermitteln gemäß:

$$t_{AB} = \frac{\Delta\varphi_F}{2\pi f}$$

Die Figur 2 zeigt beispielhaft den Spannungszeiger $\underline{U}_B$ in der komplexen Ebene für den Fall eines Zeitversatzes von 2 ms bzw. eines Fehlwinkels von 36° bei einer Netzfrequenz von 50 Hz relativ zum fiktiven "synchronen" Zeiger $\underline{U}_B$ sowie den korrespondierenden Spannungszeiger $\underline{U}_A$.

Die oben beispielhaft erläuterte Ermittlung des messgerätebedingten Zeitversatzes $t_{AB}$ kann anhand der Messwerte an beliebiger Stelle erfolgen, sei es

- an der ersten Stelle 11 bzw. durch das erste Messgerät 21, sofern dieses die Messwerte von der zweiten Stelle 12 bzw. vom zweiten Messgerät 22 erhält,
- an der zweiten Stelle 12 bzw. durch das zweite Messgerät 22, sofern dieses die Messwerte von der ersten Stelle 11 bzw. vom ersten Messgerät 21 erhält, und/oder an
- beliebiger anderer Stelle beispielsweise durch eine in der Figur 1 nicht gezeigte Zentralstelle, sofern dieses die Messwerte von der ersten und zweiten Stelle 11 und 12 bzw. vom ersten und zweiten Messgerät 21 bzw. 22 erhält.

Die obigen Verfahrensschritte führen in der Regel nur im fehlerfreien Fall zu ausreichend genauen Ergebnissen für den Zeitversatz $t_{AB}$. Eine Kontrolle auf Fehlerfreiheit lässt sich besonders einfach durchführen, indem folgende Bedingung geprüft wird:

$$\underline{I}_A - \underline{I}_B \cdot e^{-j\varphi_{Opt}} \cong 0$$

Ist die Bedingung erfüllt, kann von einem fehlerfreien Fall ausgegangen werden.

Anhand der Figur 1 wurde das Verfahren für den beispielhaften Fall von zwei Leitungsenden beschrieben; im Falle mehrerer Leitungsenden kann eine Spannungszeigerberechnung auch relativ zur Leitungsmitte erfolgen. Auf diese Weise lassen sich Phasen-Offsets zwischen den Spannungen an den Leitungsenden durch Lastströme vermeiden.

Die oben beschriebene relativ aufwändige Lösung der Optimierungsaufgabe - also die Suche des optimalen Funktionsparameterwerts $\varphi_{Opt}$, für den die Kostenfunktion minimal wird - braucht im Allgemeinen nur in größeren Zeitabständen erneut durchgeführt zu werden.

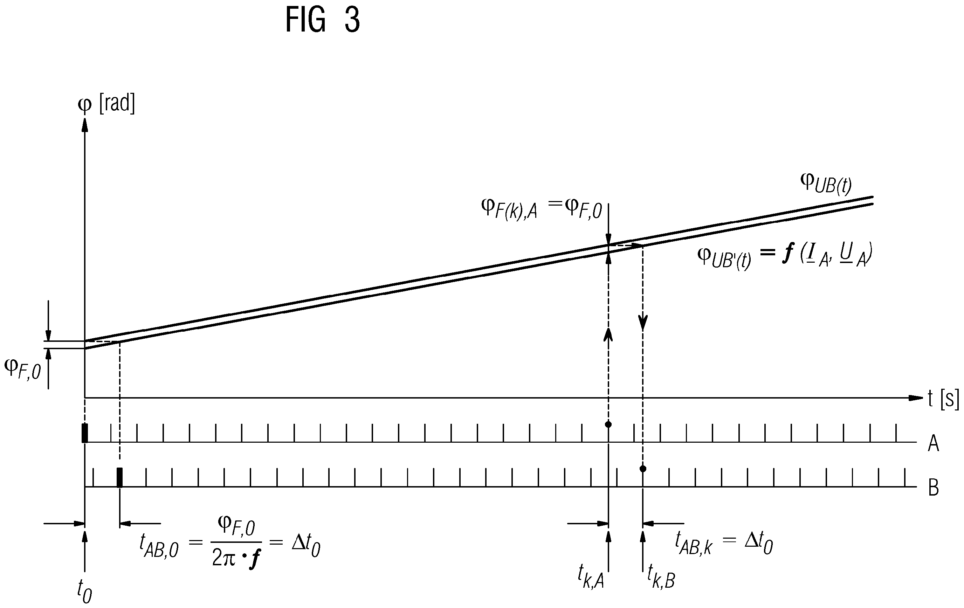

Im Folgenden wird im Zusammenhang mit den Figuren 3 bis 5 beispielhaft beschrieben, welche Aspekte zwischen zwei aufeinander folgenden Zeitpunkten betrachtet werden müssen.

Es soll zur Erläuterung in einem ersten Schritt angenommen werden, dass an beiden Stellen 11 und 12 die Abtastung mit einem konstanten Zeitversatz erfolgt ($t_{AB}$ = *const.*) . Zusätzlich seien die Abtastintervalle aller Messgeräte 21 und 22 gleich lang ($\Delta t_S$=0). Dann gilt ausgehend von einem Abtastzeitpunkt $t_0$ für jeden weiteren lokalen Abtastzeitpunkt $t_k$:

$$t_k = t_0 + k \cdot t_S$$

Die zeitliche Zuordnung der empfangenen Messwerte vom zweiten Messgerät 22 kann somit erfolgen gemäß mit:

$$t_k = t_0 + k \cdot t_S + t_{AB}$$

mit:

- $t_S$: Abtastintervall
- $t_0$: Zeit zum Einschaltzeitpunkt
- $k$: Anzahl von Abtastwerten

Die Figur 3 zeigt die Geräte-Zeitachsen mit konstantem Spannungszeigerdifferenzwinkel $\varphi_F$ und veranschaulicht die Korrektur des Fehlwinkels. Es gilt:

$$f_{S,A} = f_{S,B} \Rightarrow \Delta t_s = 0$$

Im zweiten Schritt werden abweichende Abtastfrequenzen $f_S$ zwischen beiden Messgeräten 21 und 22 berücksichtigt ($\Delta t_S \neq 0$). Für jeden lokalen Abtastzeitpunkt gilt in Bezug auf $t_0$ :

$$t_k = t_0 + k \cdot t_S$$

Die zeitliche Zuordnung der vom zweiten Messgerät 22 empfangenen Messwerte kann beispielsweise erfolgen gemäß:

$$t_k = t_0 + k \cdot \left(t_S + \Delta t_S\right) + t_{AB,0}$$

$$\Delta t_s = \frac{1}{f_{S,A}} - \frac{1}{f_{S,B}}$$

wobei die Differenz der Abtastintervalle zwischen den Messgeräten 21 und 22 angibt.

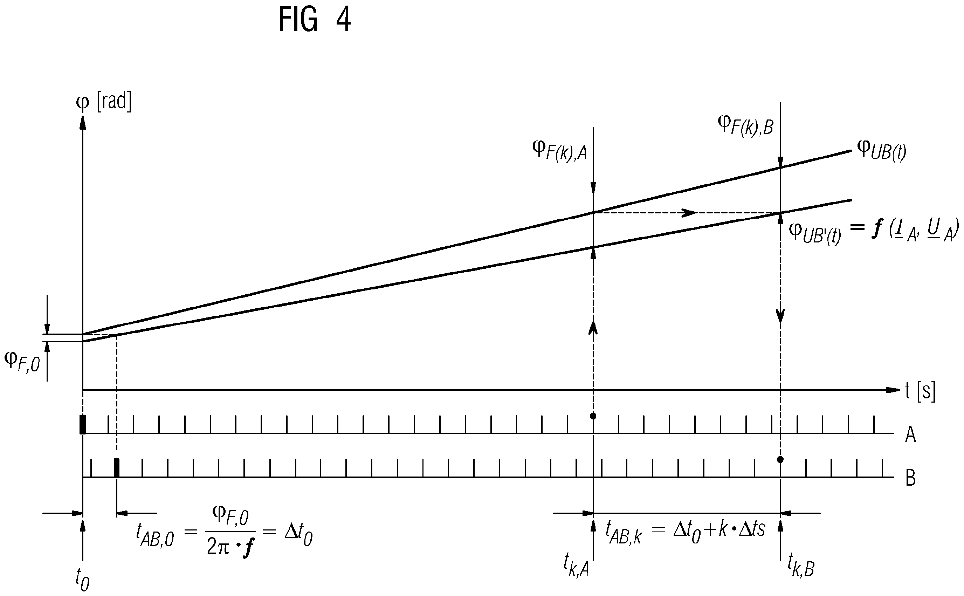

Die Figur 4 zeigt beispielhaft die Geräte-Zeitachsen auf den akkumulierten Spannungszeigerdifferenzwinkel $\varphi_F$ und veranschaulicht die Korrektur des durch abweichende Abtastfrequenzen in den Terminals entstehenden Fehlwinkels. Es gilt:

$$f_{S,A} \neq f_{S,B} \Rightarrow \Delta t_s \neq 0 :$$

Zum Zeitpunkt to wird der Fehlwinkel zwischen den Messgeräten vorzugsweise mittels der oben beschriebenen Minimierung der Kostenfunktion berechnet. Dazu werden vorzugsweise die aktuellsten vorhandenen Messwerte des eigenen und des entfernten Messgerätes verwendet, wenn die Berechnung messgeräteseitig erfolgt. Jeder folgende Messwert $\varphi_{U(k),A}$ bzw. $\varphi_{U(k),B}$ wird zum gemessenen Winkel $\varphi_{U0,A}$ bzw. $\varphi_{U0,B}$ addiert und ergibt einen akkumulierten Spannungszeigerwinkel.

Beispielsweise wird aus Sicht des ersten Messgeräts 21 mit jedem übertragenen Messwert des entfernten zweiten Messgerätes 22 auch der dazu passende akkumulierte Winkel $\varphi_{U(k),B}$ mit übertragen. Im ersten Messgerät 21 kann somit der akkumulierte Winkel $\varphi_{U(k),B'}$ gebildet werden. Über die Differenz von $\varphi_{U(k),B'}$ und $\varphi_{U(k),B}$ kann nachfolgend die jeweilige zueinander synchrone Zeitdifferenz $t_{AB,k}$, ausgedrückt durch den Winkel $\varphi_{F(k),A}$, zwischen den Messgeräten 21 und 22 berechnet werden:

$$\varphi_{F(k),A} = \varphi_{U(k),B'} - \varphi_{U(k),B}$$

Eine Umrechnung in die Zeitdifferenz für das erste Messgerät 21 erfolgt mittels

$$t_{AB} = \frac{\varphi_{F,A}}{2\pi \cdot f} = \Delta t_0 + \Delta t_{AB}$$

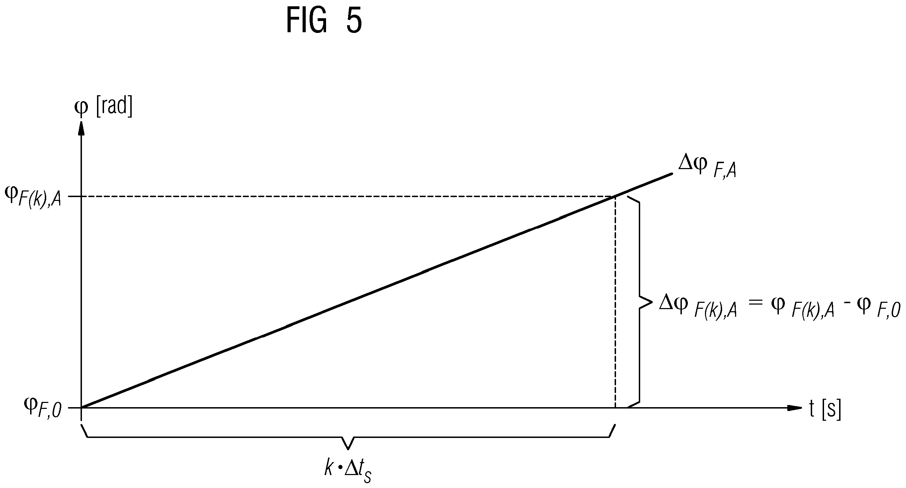

Die Figur 5 zeigt die Ermittlung der Differenz der Abtastintervalle $\Delta t_s$ .

Die Zeit $\Delta t_s$ kann durch eine lineare Gleichung der folgenden Form beschrieben werden:

$$k \cdot \Delta t_s = \Delta t_{AB(k)} = \frac{\Delta \varphi_{F(k),A}}{2\pi \cdot f}$$

mit:

- $\Delta \varphi_{F,A} = \varphi_{F(k),A} - \varphi_{F,0,A}$ (analog für das zweite Messgerät 22)
- $\Delta t_0$: Abtastzeitdifferenz zwischen den Messgeräten zum Zeitpunkt to
- $\Delta t_{AB}$: Abtastzeitdifferenz zwischen den Messgeräten seit dem Zeitpunkt to ohne $\Delta t_0$
- k: Anzahl der verarbeiteten Abtastwerte seit der letzten $t_0$ Berechnung

Der Wert $\Delta t_s$ beschreibt die Drift der Lokalzeiten der Messgeräte 21 und 22 und sollte zumindest näherungsweise konstant sein. Die Drift der Zeiten kann z. B. mittels einer Ausgleichsgeraden durch lineare Regression bestimmt werden.

Wie bereits oben angesprochen, ist es vorteilhaft, $\varphi_{U(k),B'}$ durch Akkumulation zu ermitteln, beispielsweise um nach Erreichen eines Wertes von 360° einen Rücksprung auf 0° zu vermeiden und ein Fortzählen mit 361° usw. sicherzustellen, beispielsweise wie folgt:

$$\underline{U}_B' = \underline{U}_A + \underline{Z}_{AB} \cdot \left( \underline{I}_A - \underline{U}_A \cdot \underline{Y}_{AA} \right)$$

$$\varphi_{U,B'} = \arg\{\underline{U}_B'\} = \arg\{\underline{U}_A + \underline{Z}_{AB} \cdot \left( \underline{I}_A - \underline{U}_A \cdot \underline{Y}_{AA} \right)\}$$

$$\varphi_{U(k),B'} = \varphi_{U(k-1),B'} + \arg\{\underline{U}_{A(k)} + \underline{Z}_{AB} \cdot \left( \underline{I}_{A(k)} - \underline{U}_{A(k)} \cdot \underline{Y}_{AA} \right)\}$$

Wie bereits im Zusammenhang mit den Figuren 3 bis 5 erläutert wurde, ist es vorteilhaft, nach einer Berechnung eines ersten bzw. initialen messgerätbedingten Phasendifferenzwerts, wie dies oben im Zusammenhang mit den Figuren 1 und 2 und der Minimierung der Kostenfunktion erläutert wurde, den messgerätbedingten Phasendifferenzwert zu einem vorgegebenen zweiten, späteren Zeitpunkt erneut zu ermitteln, ohne die Kostenfunktionsbetrachtung im Einzelnen zu wiederholen. Dies ist insbesondere deshalb mit großer Genauigkeit möglich, weil folgende Beziehungen gelten:

$$\Delta\varphi_{F(k),A} = \varphi_{F(k),A} - \varphi_{F(k=0),A} = \varphi_{F(k),A} - \varphi_{F,0} = (\varphi_{U(k),B} - \varphi_{U(k),B'}) - (\varphi_{U(k=0),B} - \varphi_{U(k=0),B'})$$

$$\Delta\varphi_{F(k),A} = (\varphi_{U(k),B} - (\varphi_{U(k),A} + \varphi_{U,AB})) - (\varphi_{U(k=0),B} - (\varphi_{U(k=0),A} + \varphi_{U,AB}))$$

und

$$\Delta\varphi_{F(k),A} = (\varphi_{U(k),B} - \varphi_{U(k),A}) - (\varphi_{U(k=0),B} - \varphi_{U(k=0),A})$$

weil $\varphi_{U,AB}$ (vgl. Figur 2) im Betrachtungszeitfenster zumindest näherungsweise konstant bleibt und eine Änderung der Phasenbeziehung zwischen $\underline{U}_A$ und $\underline{U}_B$ im Zeitraum zwischen k und k=0 im Wesentlichen auf der Differenz Δfs zwischen den Abtastfrequenzen in den Messgeräten 21 und 22 beruht. Es folgt:

$$\varphi_{F(k),A} = \Delta\varphi_{F(k),A} + \varphi_{F,0}$$

$$\varphi_{U(k),B'} = \varphi_{F(k),A} + \varphi_{U(k),B}$$

Der messgerätbedingte Phasendifferenzwert kann zum zweiten Zeitpunkt also ermittelt werden gemäß:

$$\varphi_{F(k),A} = \Delta\varphi_{F(k),A} + \varphi_{F,0} = (\varphi_{U(k),B} - \varphi_{U(k),A}) - (\varphi_{U(k=0),B} - \varphi_{U(k=0),A}) + \varphi_{F,0}$$

wobei bezeichnet:

$\varphi_{F(k),A}$ den Phasendifferenzwert zum zweiten Zeitpunkt,
$\varphi_{U(k=0),A}$ den Phasenwinkel des Spannungszeigers an der ersten Stelle 11 zum ersten Zeitpunkt,
$\varphi_{U(k=0),B}$ den Phasenwinkel des Spannungszeigers an der zweiten Stelle 12 zum ersten Zeitpunkt,
$\varphi_{U(k),A}$ den Phasenwinkel des Spannungszeigers an der ersten Stelle 11 zum zweiten Zeitpunkt,
$\varphi_{U(k),B}$ den Phasenwinkel des Spannungszeigers an der zweiten Stelle 12 zum zweiten Zeitpunkt und
$\varphi_{F,0}$ den messgerätebedingten Phasendifferenzwert zum ersten Zeitpunkt.

Der messgerätebedingte Verzögerungswert, der den Zeitversatz zwischen den Zeitbasen der Messgeräte zum zweiten Zeitpunkt angibt, lässt sich ermitteln gemäß:

$$\Delta t = \frac{\Delta\varphi_{F(k),A}}{2\pi f}$$

wobei Δ$t$ den messgerätebedingten Verzögerungswert und f die Netzfrequenz auf der elektrischen Leitung bzw. im elektrischen Netz bezeichnet.

Auch kann ein Frequenzdifferenzwert ermittelt werden, der die Differenz zwischen der zeitlichen Zeigerermittlungsrate des ersten Messgerätes 21 und der des zweiten Messgerätes 22 angibt, gemäß:

$$\Delta fs = \frac{\Delta\varphi_{F(k),A}}{t2 - t1}$$

wobei t2 den zweiten Zeitpunkt und t1 den ersten Zeitpunkt bezeichnet.

Der messgerätebedingte Phasendifferenzwert kann zum Verstellen der Zeigerermittlungsrate des ersten und/oder zweiten Messgerätes 21 bzw. 22 herangezogen werden, um die Messgeräte 21 und 22 miteinander zu synchronisieren.

Vorteilhaft ist es, wenn zumindest eines der Messgeräte, insbesondere das zweite Messgerät 22, seine Messzeiger an mindestens ein anderes Messgerät, insbesondere das erste Messgerät 21, übermittelt und zumindest ein Messgerät, das Messzeiger von einem anderen Messgerät empfängt, - insbesondere das erste Messgerät 21 - den messgerätebedingten Phasendifferenzwert bildet.

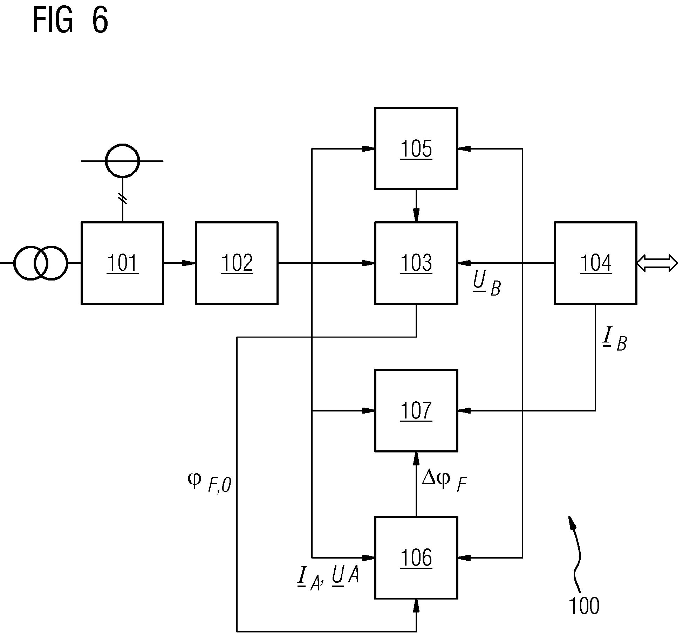

Die Figur 6 zeigt ein Blockschaltbild für ein Ausführungsbeispiel für Komponenten eines Messgeräts 100, das als das erste und/oder zweite Messgerät 21 bzw. 22 bei der Anordnung gemäß Figur 1 eingesetzt werden kann.

Ein Zeigerbestimmungsblock 102 des Messgeräts 100 liefert in bekannter Weise Strom- und Spannungszeiger für die von einem A/D-Wandler 101 gelieferten Abtastwerte des eigenen Leitungsendes, im Falle eines Einsatzes des Messgeräts 100 als das erste Messgerät 21 bei der Anordnung gemäß Figur 1, also die Strom- und Spannungszeiger an der ersten Stelle 11.

Ein Phasenversatzfunktionsblock 103 des Messgeräts 100 liefert den initialen Phasenversatz zwischen den Zeigern des eigenen Leitungsendes und den Zeigern des entfernten Leitungsendes, vorzugsweise gemäß den obigen Erläuterungen im Zusammenhang mit den Figuren 1 und 2 und der Minimierung der Kostenfunktion.

Die Zeiger des entfernten Leitungsendes werden vorzugsweise über ein Internet-Protokoll-Netzwerk empfangen, beispielsweise von einem Schnittstellenfunktionsblock 104 des Messgeräts 100.

Ein Testblock 105 des Messgeräts 100 prüft beispielsweise mittels des oben aufgeführten Stromdifferenzkriteriums die Leitung auf Fehlerfreiheit. Der Phasenversatzfunktionsblock 103 wird nur freigegeben, wenn sich die Leitung im fehlerfreien Zustand befindet und der von dem Testblock 105 durchgeführte letzte Test auf Fehlerfreiheit mindestens 5 Sekunden zurückliegt.

Ein Messwerteversatzfunktionsblock 106 des Messgeräts 100 bestimmt den jeweiligen Messwerteversatz und liefert mit Hilfe des Phasenversatzfunktionsblocks 103, der den initialen Phasenversatz anzeigt, sowie der initialen und aktuellen Spannungszeigerwinkel von beiden Stellen 11 und 12 bzw. beiden Leitungsenden die Zuordnung der Zeigermesswerte vom eigenen und entfernten Leitungsende sowie die erforderliche Phasenkorrektur.

Ein Differentialschutzblock 107 führt anhand der synchronisierten Zeiger ein Differentialschutzverfahren zum Erkennen eines Fehlers auf der überwachten Leitung durch.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

Bezugszeichen

| | |
|---|---|
| 10 | elektrische Leitung |
| 11 | erste Stelle |
| 12 | zweite Stelle |
| 13 | Masche |
| 21 | erstes Messgerät |
| 22 | zweites Messgerät |
| 100 | Messgerät |
| 101 | A/D-Wandler |
| 102 | Zeigerbestimmungsblock |
| 103 | Phasenversatzfunktionsblock |
| 104 | Schnittstellenfunktionsblock |
| 105 | Testblock |
| 106 | Messwerteversatzfunktionsblock |
| 107 | Differentialschutzblock |
| | |
| C | Parallelkapazität |
| $\underline{I}_A$ | Stromzeiger |
| $\underline{I}_B$ | Stromzeiger |
| $L_L$ | Induktivität |
| $R_L$ | Leitungswiderstand |
| $\underline{U}_A$ | Spannungszeiger |
| $\underline{U}_B$ | Spannungszeiger |
| $\underline{U}'_B$ | Spannungszeiger |

**Patentansprüche**

1. Verfahren zum Bestimmen eines Zeitversatzmesswertes, der den Zeitversatz zwischen einem ersten Messwert, der mit einem an einer ersten Stelle (11) einer elektrischen Leitung (10) oder eines elektrischen Netzes angeordneten Messgerät (21) erfasst worden ist, und zumindest einem zweiten Messwert, der mit zumindest einem an einer zweiten Stelle (12) der elektrischen Leitung (10) oder des elektrischen Netzes angeordneten Messgerät (22) ermittelt worden ist, angibt, wobei

   - als erster Messwert ein erster Messzeiger ($\underline{U}_A$) und als zweiter Messwert ein zweiter Messzeiger ($\underline{U}_B$) ermittelt wird,
   - mit dem ersten und zweiten Messzeiger unter Heranziehung eines den Leitungsabschnitt bzw. Netzabschnitt zwischen der ersten und zweiten Stelle (11, 12) beschreibenden Leitungsmodells ein leitungsbedingter Phasendifferenzwert, der den leitungsbedingten Phasenversatz ($\varphi_{U,AB}$) zwischen dem ersten und zweiten Messzeiger bei synchroner Messzeigermessung beschreibt, und ein messgerätebedingter Phasendifferenzwert ($\varphi_F$), der auf einem Zeitversatz zwischen den Messzeigern im Falle einer asynchronen Messzeigerermittlung der Messgeräte (21, 22) beruht, bestimmt wird und der Zeitversatzmesswert allein durch den messgerätebedingten Phasendifferenzwert ($\varphi_F$) oder unter Heranziehung des messgerätebedingten Phasendifferenzwerts ($\varphi_F$) gebildet wird; und

   wobei das Leitungsmodell durch eine Maschengleichung einer durch die erste und zweite Stelle (11, 12) begrenzten elektrischen Masche (13) beschrieben wird oder eine solche Masche zumindest auch umfasst,
   **dadurch gekennzeichnet, dass**

   - eine Kostenfunktion ($f(\varphi_{Opt})$), die auf der Maschengleichung basiert und einen Phasenversatz zwischen den Messzeigern als Funktionsparameter aufweist, minimiert wird und
   - der zu dem Auftreten des Minimalwerts der Kostenfunktion führende optimale Funktionsparameterwert ($\varphi_{Opt}$) als messgerätebedingter Phasendifferenzwert angesehen wird.

2. Verfahren nach Anspruch 1,
   **dadurch gekennzeichnet, dass**
   die Kostenfunktion lautet:

   $$f\left(\varphi_{Opt}\right) = abs\left(\underline{U}_A + \underline{Z}_{AB} \cdot \left(\underline{I}_A - \underline{U}_A \cdot \underline{Y}_{AA}\right) - \underline{U}'_B \cdot e^{-i\varphi_{Opt}}\right)$$

   - wobei der erste und zweite Messzeiger jeweils Spannungszeiger sind und
   - wobei $f(\varphi_{Opt})$ die Kostenfunktion, $\underline{U}_A$ den ersten Spannungszeiger, $\underline{U}_B$ den zweiten Spannungszeiger, $\underline{Y}_{AA}$ einen Parallelleitwert des Leitungsmodells, $\underline{I}_A$ einen an der ersten Stelle (11) erfassten Stromzeiger, $\underline{Z}_{AB}$ einen Leitungswiderstand des Leitungsmodells und $\varphi_{Opt}$ den optimalen Funktionsparameterwert bezeichnet.

3. Verfahren nach einem der voranstehenden Ansprüche,
   **dadurch gekennzeichnet, dass**
   der leitungsbedingte Phasendifferenzwert ermittelt wird durch Differenzbildung zwischen dem Differenzphasenwinkel zwischen dem ersten und zweiten Messzeiger und dem messgerätebedingten Phasendifferenzwert.

4. Verfahren nach einem der voranstehenden Ansprüche,
   **dadurch gekennzeichnet, dass**
   der messgerätbedingte Phasendifferenzwert zu einem vorgegebenen zweiten, späteren Zeitpunkt erneut ermittelt wird.

5. Verfahren nach Anspruch 4,
   **dadurch gekennzeichnet, dass**
   der messgerätbedingte Phasendifferenzwert zu dem zweiten Zeitpunkt unter Heranziehung eines an der ersten Stelle (11) zu dem zweiten Zeitpunkt erfassten dritten Messzeigers und dem korrespondierenden Messzeiger, nachfolgend vierter Messzeiger genannt, der zweiten Stelle (12) errechnet wird.

6. Verfahren nach einem der voranstehenden Ansprüche 4 bis 5,
   **dadurch gekennzeichnet, dass**

die Messzeiger Spannungszeiger sind und der messgerätbedingte Phasendifferenzwert zum zweiten Zeitpunkt ermittelt wird gemäß:

$$\varphi_{F(k),A} = \Delta\varphi_{F(k),A} + \varphi_{F,0} = (\varphi_{U(k),B} - \varphi_{U(k),A}) - (\varphi_{U(k=0),B} - \varphi_{U(k=0),A}) + \varphi_{F,0}$$

wobei bezeichnet:

$\varphi_{F(k),A}$ den Phasendifferenzwert zum zweiten Zeitpunkt,
$\varphi_{U(k=0),A}$ den Phasenwinkel des ersten Spannungszeigers,
$\varphi_{U(k=0),B}$ den Phasenwinkel des zweiten Spannungszeigers,
$\varphi_{U(k),A}$ den Phasenwinkel des dritten Spannungszeigers,
$\varphi_{U(k),B}$ den Phasenwinkel des vierten Spannungszeigers und
$\varphi_{F,0}$ den messgerätebedingten Phasendifferenzwert zum ersten Zeitpunkt.

7. Verfahren nach einem der voranstehenden Ansprüche 4 bis 6,
**dadurch gekennzeichnet, dass**
ein messgerätebedingter Verzögerungswert, der den Zeitversatz zwischen den Zeitbasen der Messgeräte (21, 22) zum zweiten Zeitpunkt angibt, ermittelt wird gemäß:

$$\Delta t = \frac{\Delta\varphi_{F(k),A}}{2\pi f}$$

wobei $\Delta t$ den messgerätebedingten Verzögerungswert und f die Netzfrequenz auf der elektrischen Leitung (10) bzw. im elektrischen Netz bezeichnet.

8. Verfahren nach einem der voranstehenden Ansprüche,
**dadurch gekennzeichnet, dass**
ein Frequenzdifferenzwert ermittelt wird, der die Differenz zwischen der zeitlichen Zeigerermittlungsrate des ersten Messgerätes und der des zweiten Messgerätes angibt.

9. Verfahren nach Anspruch 8,
**dadurch gekennzeichnet, dass** der Frequenzdifferenzwert ermittelt wird gemäß:

$$\Delta fs = \frac{\Delta\varphi_{F(k),A}}{t2 - t1}$$

wobei t2 den zweiten Zeitpunkt und t1 den ersten Zeitpunkt bezeichnet.

10. Verfahren nach einem der voranstehenden Ansprüche,
**dadurch gekennzeichnet, dass**
der messgerätebedingte Phasendifferenzwert zum Verstellen, insbesondere Synchronisieren, der Zeigerermittlungsrate des ersten und/oder zweiten Messgerätes (21, 22) herangezogen wird.

11. Verfahren nach einem der voranstehenden Ansprüche,
**dadurch gekennzeichnet, dass**

- zumindest eines der Messgeräte, insbesondere das zweite Messgerät (22), seine Messzeiger an mindestens ein anderes Messgerät, insbesondere das erste Messgerät (21), übermittelt und
- zumindest ein Messgerät, das Messzeiger von einem anderen Messgerät empfängt, - insbesondere das erste Messgerät (21) - den messgerätebedingten Phasendifferenzwert bildet.

12. Verfahren nach einem der voranstehenden Ansprüche,
**dadurch gekennzeichnet, dass**

- im Falle eines Fehlers, insbesondere im Falle eines Kurzschlusses, auf der elektrischen Leitung (10) neue messgerätbedingte Phasendifferenzwerte auf der Basis des vor Fehlereintritt ermittelten Frequenzdifferenzwerts berechnet, insbesondere fortgeschrieben, werden und
- eine Synchronisation der Messgeräte (21, 22) auf der Basis der neuen, insbesondere der fortgeschriebenen, messgerätbedingten Phasendifferenzwerte erfolgt.

**13.** Messgerät (21) zum Bestimmen eines Zeitversatzmesswertes, der den Zeitversatz zwischen einem ersten Messwert, den das Messgerät (21) an einer ersten Stelle (11) einer elektrischen Leitung (10) oder eines elektrischen Netzes erfasst, und zumindest einem zweiten Messwert, der mit zumindest einem an einer zweiten Stelle (12) der elektrischen Leitung (10) oder des elektrischen Netzes angeordneten zweiten Messgerät (22) ermittelt worden ist, angibt, wobei
das Messgerät (21) derart ausgebildet ist, dass es

- als ersten Messwert einen ersten Messzeiger ermittelt,
- mit dem ersten Messzeiger und einem als zweiten Messwert erhaltenen zweiten Messzeiger unter Heranziehung eines den Leitungsabschnitt bzw. Netzabschnitt zwischen der ersten und zweiten Stelle (11, 12) beschreibenden Leitungsmodells einen leitungsbedingten Phasendifferenzwert, der den leitungsbedingten Phasenversatz zwischen dem ersten und zweiten Messzeiger bei synchroner Messzeigermessung beschreibt, und einen messgerätebedingten Phasendifferenzwert, der auf einem Zeitversatz zwischen den Messzeigern im Falle einer asynchronen Messzeigerermittlung der Messgeräte (21, 22) beruht, bestimmt und

den messgerätebedingten Phasendifferenzwert als den Zeitversatzmesswert ausgibt oder den Zeitversatzmesswert unter Heranziehung des messgerätebedingten Phasendifferenzwerts bildet; und wobei das Leitungsmodell durch eine Maschengleichung einer durch die erste und zweite Stelle (11, 12) begrenzten elektrischen Masche (13) beschrieben wird oder eine solche Masche zumindest auch umfasst,
**dadurch gekennzeichnet, dass** das Messgerät (21) derart ausgebildet ist, dass es eine Kostenfunktion ($f(\varphi_{Opt})$), die auf der Maschengleichung basiert und einen Phasenversatz zwischen den Messzeigern als Funktionsparameter aufweist, minimiert und den zu dem Auftreten des Minimalwerts der Kostenfunktion führenden optimalen Funktionsparameterwert ($\varphi_{Opt}$) als messgerätebedingten Phasendifferenzwert ansieht.

**14.** Anordnung mit einem Messgerät (21) nach Anspruch 13, nachfolgend erstes Messgerät (21) genannt, und einem zweiten Messgerät (22), das die Messzeiger an der zweiten Stelle (12) der elektrischen Leitung (10) oder des elektrischen Netzes ermittelt und diese an das erste Messgerät (21) übermittelt.

**Claims**

**1.** Method for determining a time offset measurement value, which indicates the time offset between a first measurement value, which has been detected using a measurement device (21) arranged at a first location (11) in an electrical line (10) or an electrical network, and at least one second measurement value, which has been identified using at least one measurement device (22) arranged at a second location (12) in the electrical line (10) or the electrical network, wherein

- a first measurement vector ($\underline{U}_A$) is identified as the first measurement value and a second measurement vector ($\underline{U}_B$) is identified as the second measurement value,
- a line-based phase difference value, which, in the case of synchronous measurement vector measuring, describes the line-based phase offset ($\varphi_{U,AB}$) between the first and second measurement vector, and a measurement-device-based phase difference value ($\varphi_F$), which, in the event of asynchronous measurement vector determination by the measurement devices (21, 22), is based on a time offset between the measurement vectors, are determined with the first and second measurement vector using a line model that describes the line section or network section between the first and second location (11, 12) and

the time offset measurement value is formed by the measurement-device-based phase difference value ($\varphi_F$) alone or using the measurement-device-based phase difference value ($\varphi_F$); and wherein the line model is described by a mesh equation of an electrical mesh (13) delimited by the first and second location (11, 12) or at least also comprises a mesh of this kind,
**characterized in that**

- a cost function ($f(\varphi_{Opt})$), which is based on the mesh equation and has a phase offset between the measurement vectors as a function parameter, is reduced and
- the optimum function parameter value ($\varphi_{Opt}$) that leads to the occurrence of the minimum value of the cost function is considered to be the measurement-device-based phase difference value.

2. Method according to Claim 1,
   **characterized in that**
   the cost function reads:

$$f\left(\varphi_{Opt}\right) = abs\left(\underline{U}_A + \underline{Z}_{AB} \cdot \left(\underline{I}_A - \underline{U}_A \cdot \underline{Y}_{AA}\right) - \underline{U}_B' \cdot e^{-i\varphi_{Opt}}\right)$$

   - wherein the first and second measurement vector are each voltage vectors and
   - wherein $f(\varphi_{Opt})$ denotes the cost function, $\underline{U}_A$ denotes the first voltage vector, $\underline{U}_B$ denotes the second voltage vector, $\underline{Y}_{AA}$ denotes a parallel conductance of the line model, $\underline{I}_A$ denotes a current vector detected at the first location (11), $\underline{Z}_{AB}$ denotes a line resistance of the line model and $\varphi_{Opt}$ denotes the optimum function parameter value.

3. Method according to either of the preceding claims,
   **characterized in that**
   the line-based phase difference value is identified by forming the difference between the differential phase angle between the first and second measurement vector and the measurement-device-based phase difference value.

4. Method according to one of the preceding claims,
   **characterized in that**
   the measurement-device-based phase difference value is identified again at a prescribed second, later time.

5. Method according to Claim 4,
   **characterized in that**
   the measurement-device-based phase difference value at the second time is calculated using a third measurement vector detected at the first location (11) at the second time and the corresponding measurement vector, hereinafter referred to as the fourth measurement vector, of the second location (12).

6. Method according to either of the preceding Claims 4 and 5,
   **characterized in that**
   the measurement vectors are voltage vectors and the measurement-device-based phase difference value at the second time is identified in accordance with:

$$\varphi_{F(k),A} = \Delta\varphi_{F(k),A} + \varphi_{F,0} = \left(\varphi_{U(k),B} - \varphi_{U(k),A}\right) - \left(\varphi_{U(k=0),B} - \varphi_{U(k=0),A}\right) + \varphi_{F,0}$$

   wherein:

   $\varphi_{F(k),A}$ denotes the phase difference value at the second time,
   $\varphi_{U(k=0),A}$ denotes the phase angle of the first voltage vector,
   $\varphi_{U(k=0),B}$ denotes the phase angle of the second voltage vector,
   $^\wedge Pu_{(k),A}$ denotes the phase angle of the third voltage vector,
   $\varphi_{U(k),B}$ denotes the phase angle of the fourth voltage vector and
   $\varphi_{F,0}$ denotes the measurement-device-based phase difference value at the first time.

7. Method according to one of the preceding Claims 4 to 6,
   **characterized in that**
   a measurement-device-based deceleration value, which indicates the time offset between the time bases of the measurement devices (21, 22) at the second time, is identified in accordance with:

$$\Delta t = \frac{\Delta\varphi_{F(k),A}}{2\pi f}$$

wherein $\Delta t$ denotes the measurement-device-based deceleration value and f denotes the network frequency on the electrical line (10) or in the electrical network.

8. Method according to one of the preceding claims,
**characterized in that**
a frequency difference value, which indicates the difference between the temporal vector identification rate of the first measurement device and that of the second measurement device, is identified.

9. Method according to Claim 8,
**characterized in that**
the frequency difference value is identified in accordance with:

$$\Delta fs = \frac{\Delta \varphi_{F(k),A}}{t2 - t1}$$

wherein t2 denotes the second time and t1 denotes the first time.

10. Method according to one of the preceding claims,
**characterized in that**
the measurement-device-based phase difference value is used to adjust, in particular to synchronize, the vector identification rate of the first and/or second measurement device (21, 22).

11. Method according to one of the preceding claims,
**characterized in that**

- at least one of the measurement devices, in particular the second measurement device (22), transmits its measurement vectors to at least one other measurement device, in particular the first measurement device (21), and
- at least one measurement device that receives measurement vectors from another measurement device - in particular the first measurement device (21) - forms the measurement-device-based phase difference value.

12. Method according to one of the preceding claims, **characterized in that**

- in the event of a fault, in particular in the event of a short circuit, on the electrical line (10), new measurement-device-based phase difference values are calculated, in particular updated, based on the frequency difference value identified before the fault occurred, and
- the measurement devices (21, 22) are synchronized based on the new, in particular the updated, measurement-device-based phase difference values.

13. Measurement device (21) for determining a time offset measurement value, which indicates the time offset between a first measurement value, which the measurement device (21) detects at a first location (11) in an electrical line (10) or an electrical network, and at least one second measurement value, which has been identified using at least one second measurement device (22) arranged at a second location (12) in the electrical line (10) or the electrical network, wherein the measurement device (21) is configured in such a way that it

- identifies a first measurement vector as the first measurement value,
- determines a line-based phase difference value, which, in the case of synchronous measurement vector measuring, describes the line-based phase offset between the first and second measurement vector, and a measurement-device-based phase difference value, which, in the event of asynchronous measurement vector determination by the measurement devices (21, 22), is based on a time offset between the measurement vectors, with the first measurement vector and a second measurement vector obtained as the second measurement value using a line model that describes the line section or network section between the first and second location (11, 12) and

outputs the measurement-device-based phase difference value as the time offset measurement value or forms the time offset measurement value using the measurement-device-based phase difference value; and wherein the line model is described by a mesh equation of an electrical mesh (13) delimited by the first and second location (11, 12) or at least also comprises a mesh of this kind,

**characterized in that** the measurement device (21) is designed in such a way that it reduces a cost function ($f(\varphi_{Opt})$), which is based on the mesh equation and has a phase offset between the measurement vectors as a function parameter, and considers the optimum function parameter value ($\varphi_{Opt}$) that leads to the occurrence of the minimum value of the cost function to be the measurement-device-based phase difference value.

14. Arrangement having a measurement device (21) according to Claim 13, hereinafter referred to as the first measurement device (21), and a second measurement device (22), which identifies the measurement vectors at the second location (12) in the electrical line (10) or the electrical network and transmits said measurement vectors to the first measurement device (21).

**Revendications**

1. Procédé de détermination d'une valeur de mesure d'un décalage de temps, qui indique le décalage de temps entre une première valeur de mesure, qui a été relevée par un appareil (21) de mesure disposé en un premier point (11) d'une ligne (10) électrique ou d'un réseau électrique, et au moins une deuxième valeur de mesure, qui a été déterminée par au moins un appareil (22) de mesure disposé en un deuxième point (12) de la ligne (10) électrique ou du réseau électrique, dans lequel

- on détermine comme première valeur de mesure un premier vecteur ($U\__A$) de mesure et comme deuxième valeur de mesure un deuxième vecteur ($U\__B$) de mesure,
- on définit par le premier et le deuxième vecteurs de mesure, en tirant parti d'un modèle de ligne, décrivant la partie de ligne ou la partie de réseau entre le premier et le deuxième points (11, 12), une valeur de différence de phase due à la ligne, qui décrit le décalage ($\varphi_{U,AB}$) de phase due à la ligne, entre le premier et le deuxième vecteurs de mesure pour des mesures synchrones de vecteur de mesure, et une valeur ($\varphi_F$) de différence de phase due aux appareils de mesure, qui repose sur un décalage dans le temps entre les vecteurs de mesure dans le cas d'une détermination asynchrone de vecteur de mesure des appareils (21, 22) de mesure et

on forme la valeur de mesure de décalage de temps seulement par la valeur ($\varphi_F$) de différence de phase due aux appareils de mesure ou en tirant parti de la valeur ($\varphi_F$) de différence de phase due aux appareils de mesure; et dans lequel on décrit le modèle de ligne par une équation de maille d'une maille (13) électrique délimitée par le premier et le deuxième points (11, 12) ou le modèle de ligne comprend au moins également une maille de ce genre, **caractérisé en ce que**

- on minimise une fonction ($f(\varphi_{Opt})$) de coût, qui repose sur l'équation de maille et qui a un décalage de phase entre les vecteurs de mesure comme paramètre fonctionnel et
- on considère comme valeur de différence de phase due aux appareils de mesure la valeur ($\varphi_{Opt}$) de paramètre fonctionnel optimale conduisant à l'apparition de la valeur minimum de la fonction de coût.

2. Procédé suivant la revendication 1,
**caractérisé en ce que**
la fonction de coût s'énonce

$$f(\varphi_{Opt}) = abs\ (\underline{U}_A + \underline{Z}_{AB}\ (\underline{I}_A - \underline{U}_A\ \underline{Y}_{AA}) - \underline{U}_B\ e^{-\varphi_{Opt}})$$

- dans laquelle le premier et le deuxième vecteurs de mesure sont chacun des vecteurs de tension et
- dans laquelle $f(\varphi_{Opt})$ désigne la fonction de coût, $\underline{U}_A$ le premier vecteur de tension, $\underline{U}_B$ le deuxième vecteur de tension, $\underline{Y}_{AA}$ une conductance parallèle du modèle de ligne, $\underline{I}_A$ un vecteur de courant relevé au premier point (11), $\underline{Z}_{AB}$ une résistance de ligne du modèle de ligne et $\varphi_{Opt}$ la valeur optimale du paramètre fonctionnel.

3. Procédé suivant l'une des revendications précédentes,
**caractérisé en ce que**
on détermine la valeur de différence de phase due à la ligne,
en formant une différence entre l'angle de phase de différence entre le premier et le deuxième vecteurs de mesure et la valeur de différence de phase due aux appareils de mesure.

4. Procédé suivant l'une des revendications précédentes,
**caractérisé en ce que**
on détermine à nouveau la valeur de différence de phase due à l'appareil de mesure à un deuxième instant ultérieur donné à l'avance.

5. Procédé suivant la revendication 4,
**caractérisé en ce que**
on calcule la valeur de différence de phase due à l'appareil de mesure au deuxième instant, en tirant parti d'un troisième vecteur de mesure relevé au premier point (11) au deuxième instant et du vecteur de mesure correspondant, dénommé dans ce qui suit quatrième vecteur de mesure, au deuxième point (12).

6. Procédé suivant l'une des revendications 4 à 5 précédentes,
**caractérisé en ce que**
les vecteurs de mesure sont des vecteurs de tension et on détermine la valeur de différence de phase due à l'appareil de mesure au deuxième instant suivant:

$$\varphi_{F(k),A} = \Delta\varphi_{F(k),A} + \varphi_{F,0} = (\varphi_{U(k),B} - \varphi_{U(k),A}) - (\varphi_{U(k=0),B} - \varphi_{U(k=0),A}) + \varphi_{F,0}$$

dans lequel :

$\varphi_{F(k),A}$ désigne la valeur de différence de phase au deuxième instant,
$\varphi_{U(k=0),A}$ désigne l'angle de phase du premier vecteur de tension,
$\varphi_{U(k=0),B}$ désigne l'angle de phase du deuxième vecteur de tension,
$\varphi_{U(k),A}$ désigne l'angle de phase du troisième vecteur de tension,
$\varphi_{U(k),B}$ désigne l'angle de phase du quatrième vecteur de tension et
$\varphi_{F,0}$ désigne la valeur de différence de phase due aux appareils de mesure au premier instant.

7. Procédé suivant l'une des revendications 4 à 6 précédentes,
**caractérisé en ce que**
on détermine une valeur de temporisation due aux appareils de mesure, qui indique le décalage de temps entre les bases de temps des appareils (21, 22) de mesure au deuxième instant suivant :

$$\Delta t = \frac{\Delta\varphi_{F(k),A}}{2\pi f}$$

dans laquelle $\Delta t$ désigne la valeur de temporisation due aux appareils de mesure et f la fréquence du réseau sur la ligne (10) électrique ou dans le réseau électrique.

8. Procédé suivant l'une des revendications précédentes,
**caractérisé en ce que**
on détermine une valeur de différence de fréquence, qui indique la différence entre le taux de détermination de vecteur en fonction du temps du premier appareil de mesure et celui du deuxième appareil de mesure.

9. Procédé suivant la revendication 8,
**caractérisé en ce que**
on détermine la valeur de différence de fréquence suivant :

$$\Delta fs = \frac{\Delta\varphi_{F(k),A}}{t2 - t1}$$

dans laquelle t2 désigne le deuxième instant et t1 le premier instant.

10. Procédé suivant l'une des revendications précédentes,

**caractérisé en ce que**

on tire parti de la valeur de différence de phase due aux appareils de mesure pour régler, notamment synchroniser, le taux de détermination de vecteur du premier et/ou du deuxième appareil (21,22) de mesure.

11. Procédé suivant l'une des revendications précédentes,
**caractérisé en ce que**

- au moins l'un des appareils de mesure, notamment le deuxième appareil (22) de mesure, transmet son vecteur de mesure à au moins un autre appareil de mesure, notamment au premier appareil (21) de mesure et
- au moins un appareil de mesure qui reçoit des vecteurs de mesure d'un autre appareil de mesure, - notamment le premier appareil (21) de mesure - forme la valeur de différence de phase due aux appareils de mesure.

12. Procédé suivant l'une des revendications précédentes, **caractérisé en ce que**

- dans le cas d'une panne, notamment dans le cas d'un court-circuit, sur la ligne (10) électrique, on calcule, notamment on met à jour, de nouvelles valeurs de différence de phase dues aux appareils de mesure sur la base de la valeur de différence de fréquence déterminée avant l'apparition de la panne et
- on produit une synchronisation des appareils (21, 22) de mesure sur la base des nouvelles valeurs de différence de mesure dues aux appareils de mesure, notamment mises à jour.

13. Appareil (21) de mesure pour la détermination d'une valeur de mesure de décalage dans le temps, qui indique le décalage dans le temps entre une première valeur de mesure, que l'appareil (21) de mesure relève à un premier point (21) d'une ligne (10) électrique ou d'un réseau électrique, et au moins une deuxième valeur de mesure, qui a été déterminée par au moins un deuxième appareil (22) de mesure disposé au moins en un deuxième point (12) de la ligne (12) électrique du réseau électrique, dans lequel l'appareil (21) de mesure est constitué de manière

- à déterminer un premier vecteur de mesure comme première valeur de mesure,
- à déterminer par le premier vecteur de mesure et par un deuxième vecteur de mesure obtenu comme deuxième valeur de mesure en tirant parti d'un modèle de ligne, décrivant la partie de ligne ou la partie du réseau entre le premier et le deuxième point (11, 12), une valeur de différence de phase due à la ligne, qui décrit le décalage de phase due à la ligne entre le premier et le deuxième vecteur de mesure pour une mesure synchrone des vecteurs de mesure et une valeur de différence de phase due aux appareils de mesure, qui repose sur un décalage dans le temps entre les valeurs de mesure dans le cas d'une détermination asynchrone de vecteurs de mesure des appareils (21, 22) de mesure, et

à émettre la valeur de différence de phase due aux appareils de mesure comme valeur de mesure de décalage dans le temps ou la valeur de mesure de décalage dans le temps en tirant parti de la valeur de différence de phase due aux appareils de mesure et dans lequel le modèle de ligne est décrit par une équation d'une maille (13) électrique délimitée entre le premier et le deuxième point (11, 12) ou comprend au moins également une maille de ce genre, **caractérisé en ce que** l'appareil (21) de mesure est constitué de manière à minimiser une fonction ($f(\varphi_{Opt})$) de coût, qui repose sur l'équation de maille et qui a un décalage de phase entre les vecteurs de mesure comme paramètre fonctionnel et à considérer comme valeur de différence de phase due aux appareils de mesure la valeur ($\varphi_{Opt}$) de paramètre fonctionnel la meilleure conduisant à l'apparition de la valeur minimum de la fonction de coût.

14. Agencement ayant un appareil (21) de mesure suivant la revendication 13, dénommé dans ce qui suit premier appareil (21) de mesure, et un deuxième appareil (22) de mesure, qui détermine les vecteurs de mesure au deuxième point (12) de la ligne (10) électrique ou du réseau électrique et les transmet au premier appareil (21) de mesure.

FIG 1

FIG 2

FIG 3

$\varphi$ [rad]

$\varphi_{UB(t)}$

$\varphi_{F(k),A} = \varphi_{F,0}$

$\varphi_{UB'(t)} = \boldsymbol{f}\,(\underline{I}_A,\ \underline{U}_A)$

$\varphi_{F,0}$

t [s]

A

B

$t_{AB,0} = \dfrac{\varphi_{F,0}}{2\pi \cdot \boldsymbol{f}} = \Delta t_0$

$t_{AB,k} = \Delta t_0$

$t_0$

$t_{k,A}$

$t_{k,B}$

EP 3 355 432 B1

19

FIG 4

$$t_{AB,0} = \frac{\varphi_{F,0}}{2\pi \cdot f} = \Delta t_0$$

$$t_{AB,k} = \Delta t_0 + k \cdot \Delta ts$$

EP 3 355 432 B1

FIG 5

$\varphi$ [rad]

$\Delta\varphi_{F,A}$

$\varphi_{F(k),A}$

$\Delta\varphi_{F(k),A} = \varphi_{F(k),A} - \varphi_{F,0}$

$\varphi_{F,0}$

t [s]

$k \cdot \Delta t_S$

EP 3 355 432 B1

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012061978 A1
- EP 2693586 A1